Europäisches Patentamt

**European Patent Office**

**Office européen des brevets**

(19)

(11) Publication number: **0 339 090**
A1

# EUROPEAN PATENT APPLICATION

(12)

published in accordance with Art. 158(3) EPC

(21) Application number: **87907819.4**

(51) Int. Cl.⁴: **A 61 B 10/00**, G 01 N 24/08

(22) Date of filing: **27.11.87**

Data of the international appli-
cation taken as a basis:

(86) International application number:
**PCT/JP 87/00918**

(87) International publication number:
**WO 88/03780 (02.06.88 88/12)**

(30) Priority: **28.11.86 JP 2836/87**

(71) Applicant: **YOKOGAWA MEDICAL SYSTEMS, LTD, 1-3,
Sakaecho 6-chome, Tachikawa-shi, Tokyo 190 (JP)**

(43) Date of publication of application: **02.11.89
Bulletin 89/44**

(72) Inventor: **SHIMAZAKI, Toru Yokogawa Medical Systems,
Ltd., 1-3, Sakaecho 6-chome, Tachikawa-shi,
Tokyo 190 (JP)**

(74) Representative: **Henkel, Feiler, Hänzel & Partner,
Möhlstrasse 37, D-8000 München 80 (DE)**

(84) Designated Contracting States: **DE GB**

(54) **NMR IMAGING METHOD.**

(57) An NMR imaging method which produces an image free of
distortion that may be caused by chemical shift artifact or non-
uniformity of a static magnetic field even when the gradient for
reading is largely reduced to improve the SN ratio. That is, in the
NMR imaging based upon the Fourier transform, the chemical
shift imaging is effected under the conditions of measuring spin
echo signals in a field of a low reading gradient in order to ob-
tain a plurality of images that are isolated, and the plurality of
images are compensated by an amount that corresponds to the
quantity of chemical shift to thereby obtain a synthetic image.
As required, the synthetic image is compensated for its distor-
tion caused by nonuniformity of a static magnetic field.

## NMR IMAGING SYSTEM

(Technical Field)

The present invention relates to an improvement in a nuclear magnetic resonance (NMR) imaging system for obtaining a tomographic image of an object by using a Fourier transformation method and more particularly to such type of system that is adpated to improve the S/N ratio of an imaging apparatus by making use of a lowest possible readout gradient.

(Technical Background)

The NMR imaging system for obtaining a tomographic image of an object on the basis of a NMR phenomenon by taking notice of specific atomic nuclei has hitherto been known and the principle of this system is as follows.

The atomic nucleus may be considered resembling a top in rotation and when it is placed in a magnetostatic field Ho in the direction of the z-axis, it takes a precessional motion at an angular velocity expressed by the following equation which-motion is called a Larmor precessional motion.

$$\omega_0 = \gamma Ho \qquad\qquad \ldots\ldots (1)$$

wherein r represents a ratio of nuclear magnetic rotation.

Now, when a high frequency coil is arranged on an axis perpendicular to the z-axis where magnetostatic field is located and a high-frequency rotatory magnetic field rotating

1

in a x-y plane at an angular velocity $\omega$o is applied, a magnetic resonance takes place and a group of Zeeman splitting atomic nuclei at the magnetostatic field Ho moves to a higher energy level by the high-frequency magnetic field satisfying the magnetic resonance. In this case, as the ratio of nuclear magnetic rotation differs depending on the kind of atomic nucleus, it is possible to specify the atomic nuclei by the resonance frequency. Further, by measuring the intensity of the resonance, it is possible to ascertain the amount of atomic nuclei present and during the time determined by a time constant called "a releasing time after resonance" the atomic nuclei excited to the higher energy level return to a lower energy level to thereby eradiate energy.

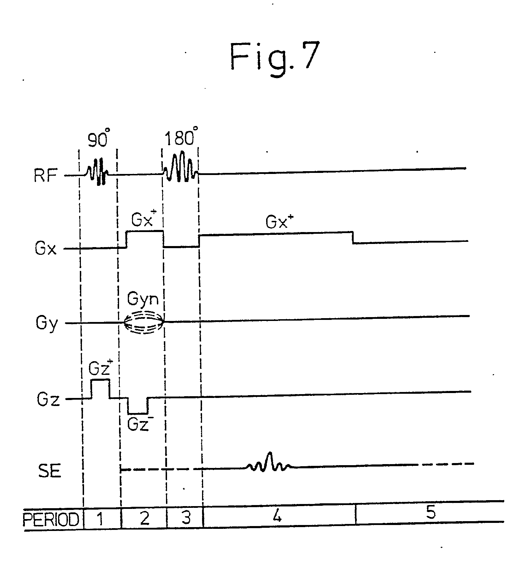

As a means of measuring NMR signals generating in the above case, there is a spin echo method as one kind of the Fourier transformation method which will now be described. The pulse sequence for measuring NMR signals corresponding to one view is as shown in Fig.7 wherein RF designates a high-frequency rotatory magnetic field for which a 90° pulse and a 180°pulse are applied on the x-axis, Gx designates a stationary gradient magnetic field to be applied on the x-axis, Gy designates a variable gradient magnetic field, Gz designates a stationary gradient magnetic field to be applied on the z-axis and SE designates a spin echo signal. In the period 1 a spin about z = 0 in a slice plane perpendicular to the z-axis is selectively excited by the 90°
pulse and the gradient magnetic field $Gz^-$. $Gx^+$ in the
period 2 is for inverting the phase of the spin by the 180°
pulse and called a diphase gradient which restores the phase
of the spin disturbed by $Gz^-$ and $Gz^+$. Gyn is also applied in
this period 2 so as to shift the phase of the spin in proportion to the position in the y-direction with its intensity
being controlled to vary per view. In the period 3, the 180°
pulse is applied to regulate the magnetic moment again so as
to observe a spin echo signal to appear thereafter. Further,
$Gx^+$ in the period 4 is a gradient magnetic field for causing a
spin echo signal to generate. It is called a readout gradient
and the peak of the spin echo signal appears where the area of
the waveform of the readout gradient and that of the waveform
of the diphase gradient become equal.

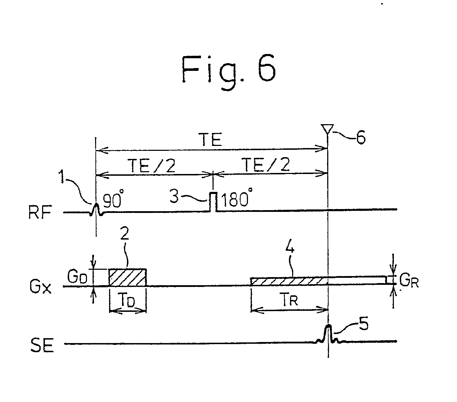

The timing relationships between the pulse sequences of
the high-frequency pulse RF and the gradient magnetic field
Gx, and the spin echo signal SE in the measurement according
to the spin echo method are shown in more detail in Fig.6.
In this figure, assuming that the pulse amplitude of the diphase gradient 2 be $G_D$ , the pulse width be $T_D$ , the pulse
amplitude of the readout gradient 4 be $G_R$  and the duration
of the pulse be $T_R$ , the spin echo signal 5 whose peak is at
$T_R$  and which satisfies the following equation will be in-
duced.

3

$$G_D \cdot T_D = G_R \cdot T_R \qquad \ldots\ldots(2)$$

Now, assuming that the duration of time from the application of the 90° pulse 1 to the point 6 of appearance of peak of the spin echo signal 5 be TE (the point 6 is hereinafter called the "TE point), the space between the 90°pulse 1 and 180° pulse 3 will be TE/2. Thus the spin echo signal is measured by the above pulse sequence and on the basis of the signal, the image is reconstructed.

Considering the proton of the nucleus of a hydrogen atom, it is general that within a substance, the NMR resonance frequency often deviates from the above-mentioned equation (1) which is a conditional expression of resonance due to the magnetostatic field Ho applied from outside. One of the causes of such deviation is the generation of a magnetic field (or diamagnetic field) in a direction reverse to Ho due to the orbital motion of electrons and this phenomenon is called a nuclear shielding effect by electrons. Accordingly, the resonance frequency is expressed by the following equation by using a constant ∅:

$$\nu = (\gamma /2\pi)\, Ho\, (1 - \emptyset) \qquad \ldots\ldots (3)$$

The above deviation of the resonance frequency is called a chemical shift. Under this phenomenon, the density of distribution of electrons and the orbital motions thereof change due to chemical combinations which results in varying the value of ∅, so that the resonance conditions vary depend-

4

ing on the kind of a chemical compound with respect to the same atom.

Where an object is imaged by using a Fourier transformation method, if the amplitude $G_R$ of the readout gradient 4 is made small when the time space TE is large, the S/N ratio may be improved since the noise band becomes narrow but it has been usual that a chemical artifact (in which water and fat are seen deviated) due to the above-mentioned chemical shift appears by the degree to which the frequency resolution is fractionized or a distortion resulting from irregularities of the static magnetic field so that the amplitude $G_R$ of the readout gradient 4 can only be made low to some degree and the improvement of S/N ratio is limited.

(Dsiclosure of the Invention)

An object of the present invention is to provide a NMR imaging system capable of obtaining an object image free of any chemical artifact or distortion due to an irregular magnetostatic field even when the readout gradient is made exremely low so as to improve the S/N ratio of the imaging apparatus.

The present invention features that in the case of NMR imaging based on a Fourier transformation method, a plurality of separate images are obtained by imaging a chemical shift under the condition of measuring a spin echo signal with a low readout gradient and then obtaining a single synthesized image by correcting the separate images in correspondence to the amount of the chemical shift. Where necessary, the synthesized image may be corrected of its distortion due to irregularities of the magnetostatic field.

(Brief Description of the Invention)

Fig.1 is a diagram showing a pulse sequence used in one embodiment of the present invention

Figs.2A through 2C are diagrams illustrating how a chemical shift is corrected;

Figs.3A and 3B are diagrams illustrating how an image distortion is corrected;

Figs.4A and 4B are diagrams showing pulse sequences for measuring the degree of irregularities of a magnetostatic field;

Figs.5A and 5B are diagrams showing pulse sequences for measuring a chemical shift; and Figs.6 and 7 are diagrams illustrating pulse sequences according to a spin echo method.

(Best Mode for working the Invention)

The present invention will now be described in detatil with reference to the accompanying drawings. For convenience sake, before describing a NMR imaging system as one embodiment of the present invention, a description is made of the measurement of the degree of irregularities of a magnetostatic field and the imaging of a chemical shift according to a known method.

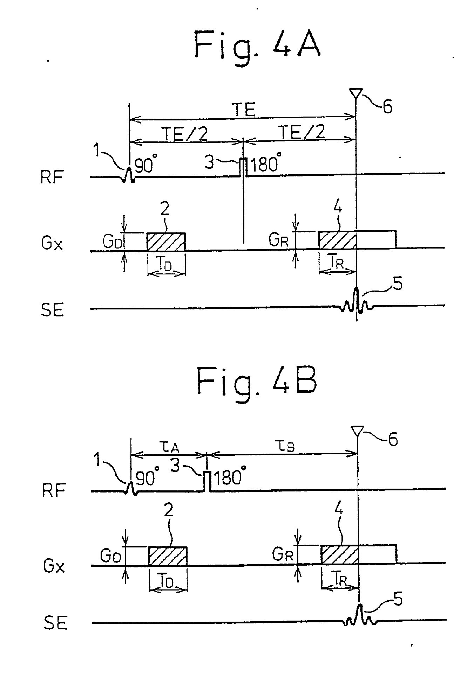

The measurement of the degree of magnetostatic irregularities is performed as follows: First, a water phantom sufficient to cover the imaging area is imaged according to the sequences shown in Figs.4A and 4B wherein like parts are designated by like reference numerals or symbols with respect to
Fig.6. Fig.4A shows a pulse sequence for obtaining an ordinary
spin echo signal in which the amplitude $G_D$ of the diphase
gradient 2 and the amplitude $G_R$ of the readout gradient 4 are
made equal to each other. Fig.4B shows a pulse sequence in
which the space between a 90° pulse and a 180° pulse is set
to $\tau_A$ and the space between the 180° pulse and the TE point 6
is set to $\tau_B$ while the value of $\tau = \tau_B - \tau_A$ is properly
set other than zero. In this case, the amplitudes $G_D$ and $G_R$
are made equal to each other. Further, assuming that an image
obtained on the basis of the spin echo signal measured by the
sequence of Fig.4A be P and an image obtained on the basis of
the spin echo signal measured by the sequence of Fig.4B be Q,
the phase difference θ between both images may be obtained by
the following equation with x- and y-axes as coordinates for
each of pixels on the images provided that P and Q are com-
plex data:

$$e^{j\theta(x,y)} = Q(x,y) / P(x,y) \quad \ldots\ldots(4)$$

and on the basis of this value of phase difference, the distribution Bo (x , y) of the degree of magnetostatic irregularities at each point may be obtained by the following equa-

7

tion:

$$\triangle Bo (x , y) = \theta (x , y) / 2 \pi r \tau \qquad ......(5)$$

Thus, if such distribution of the degree of magnetostatic irregularities, the positional and density distortions due to the irregularities may be corrected in the imaging area by a known method of causing each pixel to assume the original position and density.

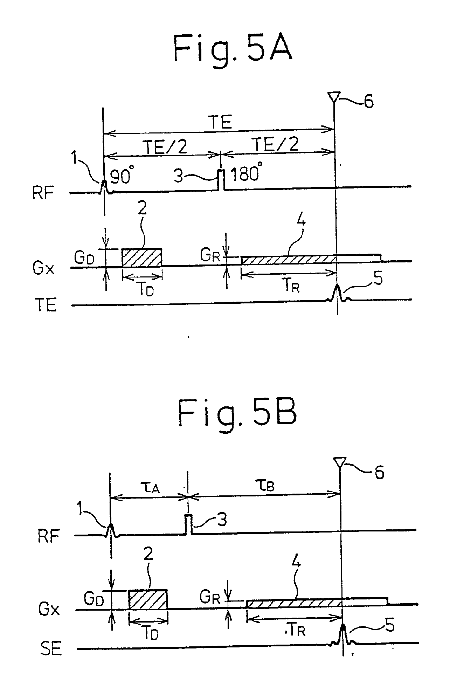

Next, the imaging of a chemical shift is performed as follows by, for example, a method known as the Dixon method. Figs.5A and 5B are diagrams showing pulse sequences for performing this imaging which sequences are similar to those shown in Figs.4A and 4B. The only difference resides in that in the case of the chemical shift imaging, the time space TE is made larger so that the amplitude $G_R$ of the readout gradient 4 is made smaller that the amplitude $G_D$ of the diphase gradient. Further, it is assumed in this measurment that the slice plane is one whose degree of magnetostatic irregularities has already been clarified in advance by the above method.

Further, the following relationship exists between the amount $\sigma$ (Hz) of chemical shift between two spin echo signals sought to be separated, and $\tau ( = \tau_B - \tau_A )$.

$$\sigma = 1 / (2 \tau) \qquad ......(6)$$

As the chemical shift between water and fat is 3.5ppm, the value of $\tau$ is readily determined only if the intensity

8

of the magnetostatic field is determined. Assuming that the image based on the spin echo signal measured in the state of $\tau = 0$ by the sequence of Fig.5B be $1$ and the image based on the spin echo signal measured in the state of $\tau = 1 / (2\sigma)$ be $I_B$, the image $I_R$ of water and the image $I_F$ of fat may be obtained by applying the following equation to each pixel.

$$I_R = ( I_A + I_B ) / 2$$

$$I_F = ( I_A - I_R ) / 2 \qquad \ldots\ldots(7)$$

provided that the images $I_A$ and $I_B$ shall be corrected in advance of their phase distortions due to magnetostatic field irregularities.

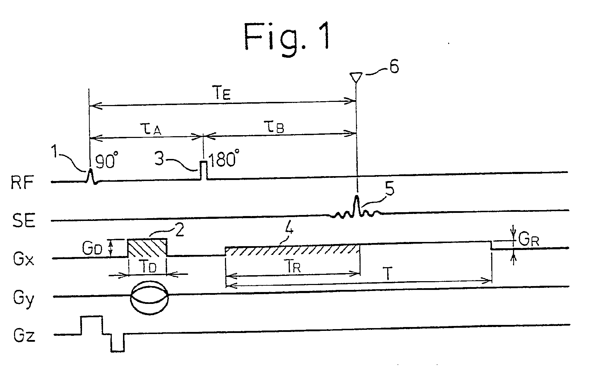

Now, based on the correction of magnetostatic irregularities and the chemical shift imaging described above, the imaging with a favorable S/N ratio according to the present invention is performed in the following manner. Fig.1 is a diagram of a pulse sequence employed in the NMR imaging system as one embodiment of the present invention. Although the pulse sequence in this figure is basically similar to those employed in the chemical shift imaging in Figs.5A and 5B, the former is characterized by the provision of a longer TE. Further, T which represents a data sampling time by the readout gradient is set to the maximum length so that it reaches near the TE. In this sequence, like the above-mentioned chemical shift imaging, the image $I_A$ based on the spin echo signal measured in the state of $\tau = 0$ and the image $I_B$ based on the spin echo

9

signal measured in the state of $\tau = 1 / (2\sigma)$ are obtained and from these images, the water and fat images $I_R$ and $I_F$ are obtained according to the above-mentioned equations (7). In this case, as $T_R$ becomes long, the amplitude $G_R$ of the readout gradient 4 satisfying the conditions of the equation (2) for generating an echo at the TE point 6 becomes innevitably small so that reading with a favorable S/N ratio is made possible by the low gradient magnetic field.

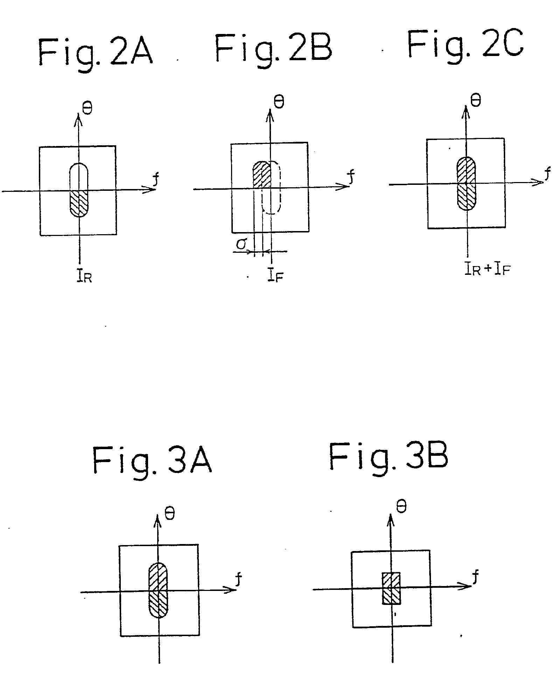

There is a frequency shift of 3.5ppm between the water and fat images obtained by the above sequences, due to the chemical shift and this state may be conceptually shown in terms of a two-dimensional Fourier plane as in Figs.2A and 2B. Fig.2A shows a water image $I_R$ and Fig.2B shows a fat image $I_F$ and between the two images, there is a predetected deviation $\sigma$ on a frequency encoding axis f. Therefore, when the image I is shifted by $\sigma$ in the reverse direction and then a part of the image lying in the positive area with respect to a phase encoding axis $\theta$ is combined with a part of the water image $I_R$ lying in the negative area with respect to the phase encoding axis $\theta$, a combined image of water and fat which is free of any chemical shift deviation and has a favorable S/N ratio as shown in Fig.2C is obtained. However, this combined image generally includes distortions with respect to its position and density due to irregularities of the magnetostatic field and therefore, these distortions are corrected by a known method by using data regarding the magnetostatic field irregularity distribution measured in advance by the sequences shown in Figs.4A and 4B. That is, the distorted image of Fig.3A is corrected of its distortion as shown in Fig.3B and then the corrected image is subjected to a two-dimensional reverse Fourier transformation thereby obtaining a tomographic image of the object. Thus, according to the imaging system in the instant embodiment, it is possible to obtain an image free of any chemical artifact and distortion due to magnetostatic field irregularities by applying an extremely low readout gradient magnetic field.

It should be noted that the present invention is not always limited to the above-described embodiment. That is, the pulse sequences are not always limited to the spin echo method but , for example, an inversion recovery method may be used if the two-dimensional Fourier transformation method is used side by side. Further, the chemical shift imaging is not always limited to the Dixon method but other suitable methods may be used. In addition, the separate images obtained by the chemical shift imaging are not always limited to the two images of water and fat but they may be more than 3 in number. The correction of the image based on the measurement of the degree of magnetostatic irregularities is not always limited to the aforementioned method but may be performed by other methods. In this connection, where the degree of magnetostatic irregularities is sufficiently small, such correction is of course not necessary.

Further, it should also be noted that although the present invention has been desribed in the foregoing with respect to the best mode for working the invention, various modifications or alterations can be easily made by a person with ordinary knowledge in the field of art to which the invention belongs, without departing from the scope of the appended claims.

WHAT IS CLAIMED IS:

1.    A NMR imaging system based on a Fourier transformation method, which is characterized by the steps of obtaining a plurality of separate images of an object by imaging a chemical shift under a condition of measuring a spin echo signal with a low readout gradient magnetostatic field and synthesizing said plurality of images into a single image by correcting said images in correspondence to the amount of said chemical shift.

2.    A NMR imaging system according to Claim 1, which further includes the step of correcting a distortion of said synthesized image due to irregularities of a magnetostatic field used.

3.    A NMR imaging system based on a Fourier transformation method, which is characterized by the steps of obtaining separate images of water and fat of an object by imaging a chemical shift under a condition of measuring a spin echo signal with a low readout gradient magnetic field and obtaining a single synthesized image by correcting said images of water and fat in correspondence to the amount of said chemical shift.

4.    A NMR imaging system according to Claim 3, which further includes the step of correcting a distortion of said synthesized image due to irregularities of a magnetostatic field used.

13

# Fig. 1

Fig. 2A  Fig. 2B  Fig. 2C

Fig. 3A  Fig. 3B

# Fig. 4A

# Fig. 4B

# Fig. 5A

# Fig. 5B

# Fig. 6

# Fig.7

# INTERNATIONAL SEARCH REPORT     0 339 090

International Application No PCT/JP87/00913

**I. CLASSIFICATION OF SUBJECT MATTER** (if several classification symbols apply, indicate all) ³

According to International Patent Classification (IPC) or to both National Classification and IPC

Int.Cl⁴    A61B10/00, G01N24/08

**II. FIELDS SEARCHED**

| Minimum Documentation Searched ⁴ | |
|---|---|
| Classification System | Classification Symbols |
| IPC | A61B10/00, G01N24/08 |

| Documentation Searched other than Minimum Documentation to the Extent that such Documents are Included in the Fields Searched ⁵ | |
|---|---|
| Jitsuyo Shinan Koho | 1960 – 1987 |
| Kokai Jitsuyo Shinan Koho | 1971 – 1987 |

**III. DOCUMENTS CONSIDERED TO BE RELEVANT** ¹⁴

| Category * | Citation of Document, ¹⁶ with indication, where appropriate, of the relevant passages ¹⁷ | Relevant to Claim No. ¹⁹ |
|---|---|---|
| Y | JP, A, 61-226648 (Hitachi, Ltd.) 8 October 1986 (08. 10. 86) Page 2, lower right column, line 3 to page 4, upper right column, line 19 (Family: none) | 1, 2 |
| Y | JP, A, 54-158988 (James MacDonald Strackson Hatchson) 15 December 1979 (15. 12. 79) Page 3, upper left column, lines 2 to 8 & DE, A1, 283380 & US, A, 4290019 & GB, A, 1601970 | 1, 2 |
| P | JP, A, 62-50650 (Hitachi, Ltd.) 5 March 1987 (05. 03. 87) Page 5, lower left column, line 13 to page 6, lower right column, line 3 (Family: none) | 1, 2 |
| P | JP, A, 62-66846 (Hitachi, Ltd.) 26 March 1987 (26. 03. 87) Page 2, upper left column, line 12 to page 3, upper right column, line 9 | 3, 4 |

* Special categories of cited documents: ¹⁶

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

**IV. CERTIFICATION**

| Date of the Actual Completion of the International Search ³ | Date of Mailing of this International Search Report ³ |
|---|---|
| February 19, 1988 (19.02.88) | March 7, 1988 (07.03.88) |
| International Searching Authority ¹ | Signature of Authorized Officer ¹⁰ |
| Japanese Patent Office | |

Form PCT/ISA/210 (second sheet) (October 1977)

| FURTHER INFORMATION CONTINUED FROM THE SECOND SHEET | | |
|---|---|---|
| P | (Family: none)<br><br>JP, A, 62-72346 (Technicare Corporation)<br>2 April 1987 (02. 04. 87)<br>Page 7, upper right column, line 16 to<br>page 13, lower right column, line 4<br>(Family: none) | 3, 4 |

**V.☐ OBSERVATIONS WHERE CERTAIN CLAIMS WERE FOUND UNSEARCHABLE [10]**

This international search report has not been established in respect of certain claims under Article 17(2) (a) for the following reasons:

1.☐ Claim numbers........... because they relate to subject matter [12] not required to be searched by this Authority, namely:

2.☐ Claim numbers........... because they relate to parts of the international application that do not comply with the prescribed requirements to such an extent that no meaningful international search can be carried out [13], specifically:

**VI.☐ OBSERVATIONS WHERE UNITY OF INVENTION IS LACKING [11]**

This International Searching Authority found multiple inventions in this international application as follows:

1.☐ As all required additional search fees were timely paid by the applicant, this international search report covers all searchable claims of the international application.

2.☐ As only some of the required additional search fees were timely paid by the applicant, this international search report covers only those claims of the international application for which fees were paid, specifically claims:

3.☐ No required additional search fees were timely paid by the applicant. Consequently, this international search report is restricted to the invention first mentioned in the claims; it is covered by claim numbers:

4.☐ As all searchable claims could be searched without effort justifying an additional fee, the International Searching Authority did not invite payment of any additional fee.

Remark on Protest

☐ The additional search fees were accompanied by applicant's protest.

☐ No protest accompanied the payment of additional search fees.

Form PCT/ISA/210 (supplemental sheet (2)) (October 1981)